# EUROPEAN PATENT APPLICATION

(11) **EP 1 998 377 A2**
(43) Date of publication of application: **03.12.2008**
(21) Application number: 08103646.9
(22) Date of filing: 22.04.2008
(51) Int. Cl.: H01L 31/0203

(54) **Concentration photovoltaic module**

(30) Priority: 31.05.2007 TW 96119497
(71) Applicant: Delta Electronics, Inc., Taoyuan Hsien 333 (TW)
(72) Inventor: Lai, Jong-Yen, 333, Taoyuan Hsien (TW); Wei, Chih-Hung, 333, Taoyuan Hsien (TW); Hsieh, Yu-Ping, 333, Taoyuan Hsien (TW)
(74) Representative: 2K Patentanwälte Kewitz & Kollegen

(57) **Abstract**

A concentration photovoltaic module includes a substrate, a first electrode, a second electrode, a solar cell, at least one electrical connecting element and a frame. The first electrode and the second electrode are disposed in different predetermined positions of the substrate to form a first electrode and a second electrode, respectively. The solar cell is disposed on the first electrode. The electrical connecting element electrically interconnects the second electrode and the solar cell. The frame straddles on the substrate, wherein the solar cell is located in the frame.

## Description

### BACKGROUND OF THE INVENTION

### Field of the Invention

The invention relates to a concentration photovoltaic module, and more particularly to a solar cell module with a frame filled with a medium to prevent the outside environment from damaging the solar cell therein.

### Description of the Related Art

In recent years, demand for energy has increased rapidly as industry and commerce developed continuously, and, however, the world population has been increasing also. Much attention for petrochemical energy resources has been drawn to decreasing the usage of petrochemical energy resources and environmental pollution. Thus, alternative energy resources continue to be developed in efforts to solve the above-mentioned problems. The development of solar energy, such as solar cells, is targeted to replace fossil fuels. Solar energy, which helps ease the consumption of fossil fuels, is not only available but also friendly to environment. However, in the light to electricity transformation process for presently developed solar cells, the solar cell is unable to efficiently absorb the incidental light spectrum and transform light into electricity. Specifically, about half of the photon energy has no contribution to the solar cell output due to its spectrum smaller than minimal conversion spectrum of semiconductor band gap. Meanwhile, of the absorbed other half of the photon energy, half is provided to electron-hole pairs, and the other half is released as heat. Currently, the best absorption efficiency of a single crystal silicon is about twenty percent, and the efficiency of a III - V semiconductor is about forty percent. However, it is necessary for solar cells to be placed in an outdoor environment to absorb sufficient light to generate electricity. Thus, undesirable or constantly change of outside environment may reduce lifespan and efficiency of the solar cell. Package design and materials selected are also the keys to the lifespan and reliability of solar cells.

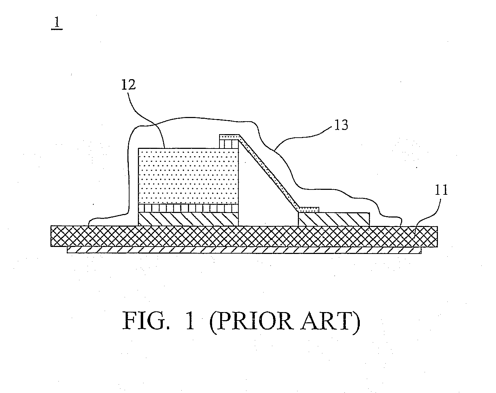

Fig. 1 shows a sectional view of a conventional concentration photovoltaic module 1. In conventional technology, a solar cell 12 disposed on a substrate 11 is packaged via insulating materials (e.g. polymer 13) to avoid atmospheric dirt contact, which would decrease efficiency of the solar cell. By the conventional package method, the incidental light spectrum and reflection of solar light is affected by the package surface profile of the polymer 13. Thus, a bad package directly decreases the energy absorption efficiency of the solar cell 12. When the polymer 13 contacts air for a long time, moisture absorption may occur and effect of isolation and protection is seriously reduced. Therefore, a bad package can affect the lifespan and efficiency of solar cells.

### BRIEF SUMMARY OF THE INVENTION

An object of the present invention is to provide a concentration photovoltaic module including a solar cell module. A frame is located in the solar cell module. An optical element is disposed on the frame. The frame has a cavity to install a solar cell. The cavity is filled with a transparent adhesive or a polymer material having better transmittance and insulating effect to prevent the solar cell from contacting the outside environment and raise the efficiency of the solar cell.

Another object of the present invention is to raise the efficiency of the solar cell by controlling a height of the frame to adjust a distance and a parallelism parameter between the optical element disposed on the frame and the solar cell installed in the cavity of the frame.

The present invention provides a concentration photovoltaic module including a substrate, a plurality of electrodes, a solar cell, at least one electrical connecting element, a frame and an optical element. The electrodes include a first electrode and a second electrode disposed in different predetermined positions on the substrate, respectively. The solar cell includes a first electrode electrically connected to the first electrode, and a second electrode electrically connected to the second electrode. The frame is made of a ceramic material, straddles on the substrate and includes a cavity, wherein the solar cell is installed in the cavity. The optical element is installed in an annular groove of the upper frame. The cavity, assembled by the optical element and the frame, is filled with a medium or without any material.

The first electrode and one electrode of the solar cell are of the same polarity, and the second electrode and the other electrode of the solar cell are of the same polarity, and the first electrode and the second electrode are opposite in polarity. The optical element is a transparent protect cover, a polymer, a lens or an optical element having high transmittance. The medium is a transparent adhesive or a polymer material having high transmittance and insulating effect.

### BRIEF DESCRIPTION OF THE DRAWINGS

The invention can be more fully understood by reading the subsequent detailed description and examples with references made to the accompanying drawings, wherein:

Fig. 1 is a sectional view of a conventional concentration photovoltaic module.

Fig. 2 is an exploded view of a concentration photovoltaic module of a first embodiment of the invention.

Fig. 3 is an assembling stereogram of a concentration photovoltaic module of a first embodiment of the invention.

Fig. 4 is a plan view of a concentration photovoltaic module of a first embodiment of the invention.

Fig. 5 is a sectional view of a concentration photovoltaic module of a first embodiment of the invention.

Fig. 6 is a sectional view of a concentration photovoltaic module of a second embodiment of the invention.

Fig. 7 is a sectional view of a concentration photovoltaic module of a third embodiment of the invention.

Fig. 8 is a sectional view of a concentration photovoltaic module of a fourth embodiment of the invention.

### DETAILED DESCRIPTION OF THE INVENTION

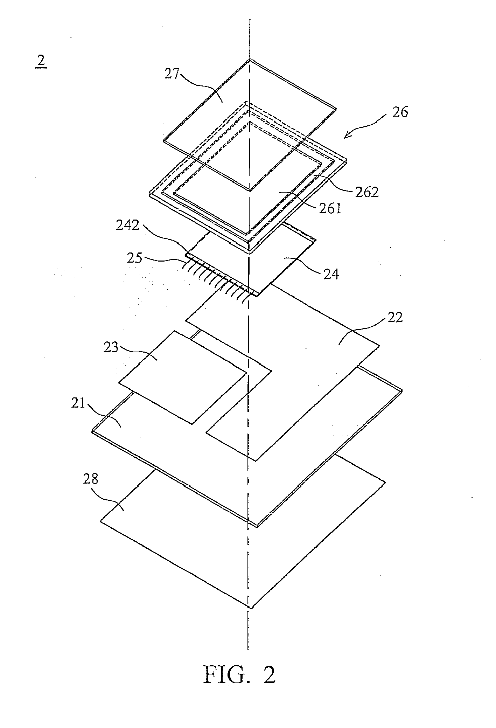

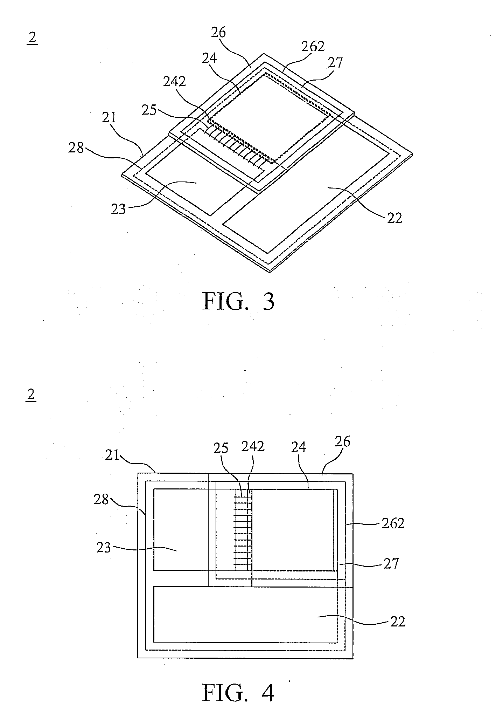

Figs. 2-5 show a concentration photovoltaic module 2 of a first embodiment of the invention. The concentration photovoltaic module 2 includes a substrate 21, a first electrode 22, a second electrode 23, a solar cell 24, a plurality of electrical connecting elements 25, a frame 26, an optical element 27, a connecting layer 28 and a medium 29.

The substrate 21 may be made of ceramic, sapphire, aluminum nitride (A1N), silicon carbide (SiC), beryllium oxide (BeO) or other materials. The first electrode 22 and the second electrode 23 are formed in different predetermined positions of the substrate 21 and electrically connected to the positive electrode 241 and the negative electrode 242 of the solar cell 24 to have positive polarity and negative polarity, respectively. The first electrode 22 and the second electrode 23 are respectively connected to the conductive wires for transmitting electrical energy from the solar cell to an electrical device electrically connected to the other ends of the conductive wires, and providing electrical energy for the electrical device to operate. Alternatively, the first electrode 22 can be a negative polarity and the second electrode 23 can be a positive polarity which is opposite to the first electrode 22.

The solar cell 24 includes a positive electrode 241 and a negative electrode 242. The solar cell 24 is a photoelectric device having a function of transforming the photovoltaic energy into electrical energy. The assembly and theory of the solar cell 24 are well-known and thus not described. The solar cell 24 is connected to the first electrode 22 by tin soldering or conductive adhesive. The first electrode 22 is electrically connected to the positive electrode 241 of the solar cell 24, and the second electrode 23 is electrically connected to the negative electrode 242 of the solar cell 24 by a plurality of electrical connecting elements 25. The first electrode 22 and the second electrode 23 have opposite polarities, wherein the first electrode 22 and the electrode 241 of the solar cell 24 are of the same polarity, and the second electrode 23 and the electrode 242 of the solar cell 24 are of the same polarity.

The frame 26 is substantially rectangular in the first embodiment, but may be round, polygonal or shaped in other geometric configurations in other embodiments. The frame 26 is made of a ceramic material and includes a cavity 261, and an internal annular groove 262 with predetermined depth is provided on the upper part of the frame 26, wherein the frame 26 straddles on the substrate 21 for allowing the solar cell to be disposed therein.

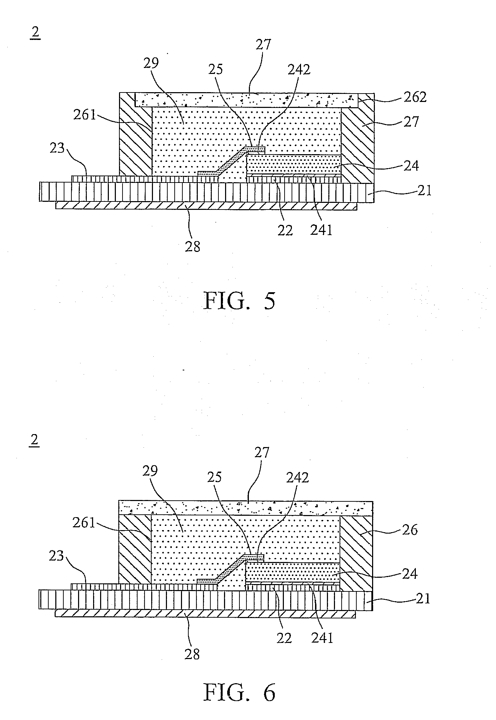

The optical element 27 may be a transparent protect cover, a polymer, a reflecting mirror, a lens or other optical elements with high transparency. The optical element 27 is installed in the annular groove 262 to package the cavity 261 and prevent the solar cell 24 in the cavity 261 from contacting outside environmental factors (e.g. surrounding vapor, corrosive and dust). Referring to Fig.6, the second embodiment of the invention is shown. In the second embodiment, the framer 26 doesn't have the annular groove 262, and the optical element 27 is directly installed on the frame 26.

The connecting layer 28 is disposed under the substrate 21 via coating or printing. In the first embodiment, the connecting layer 28 may be silver paste and connected to a heat dissipating seat to conduct the heat from the concentration photovoltaic module 2 to the heat dissipating seat.

The medium 29 may be a transparent adhesive or a polymer material with high transmittance and good insulating property. The medium 29 is chosen to have a refractive index close to the optical element 27. Empty space of the cavity 261 is filled with the medium 29. The medium 29 tightly adheres to the optical element 27 and covers the solar cell 24 to provide isolation and protection functions. Furthermore, the medium 29 tightly adheres to the optical element 27. As a result, more light can pass through the medium 29 and the optical element 27 when the refractive indexes of the medium 29 and the optical element 27 are close to each other. Thus, the efficiency of absorbing solar energy can be increased.

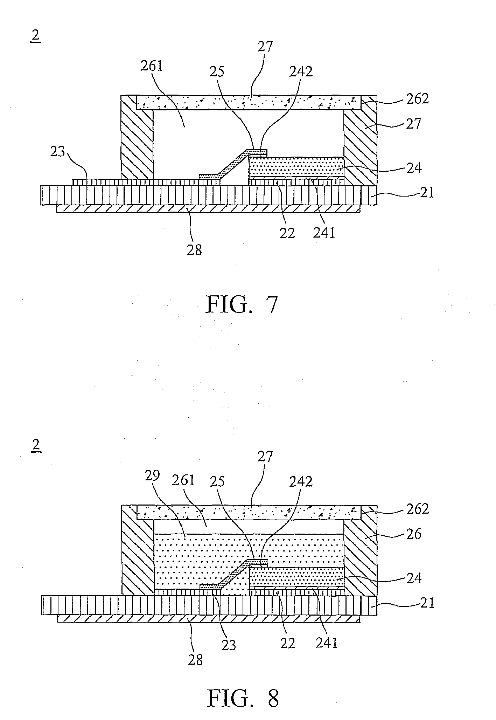

Referring to Fig. 7, a sectional view of a concentration photovoltaic module of a third embodiment of the invention is shown. In this embodiment, the cavity 261 inside is not provided with any medium, and air inside the cavity 261 is a medium for solar conduction. Referring to Fig. 8, a fourth embodiment of the invention is shown. In this embodiment, the cavity 261 is filled with a proper quantity of a medium for packaging the solar cell 24.

For above description, the invention discloses the concentration photovoltaic module 2 including the frame 26 disposed on the substrate 21 and the optical element 27 disposed on the frame 26. The solar cell 24 is disposed in the cavity 261 which includes the framer 26 and the optical element 27, and then a package process is performed inside the cavity 261. Furthermore, in above design, the solar cell 24 can be effectively protected by the frame 26 and the optical element 27 from outside environment (e.g. surrounding vapor, corrosives and dust) and the profile of the concentration photovoltaic module is improved. The invention can control a height of the frame 26 to adjust a distance and a parallelism parameter between the optical 27 and the solar cell 24 to improve the solar energy absorption efficiency of the solar cell 24.

While the invention has been described by way of example and in terms of preferred embodiment, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A concentration photovoltaic module comprising:
a substrate (21);
a first electrode (22) and a second electrode (23) disposed on the substrate, respectively;
a solar cell (24) disposed on the first electrode;
at least one electrical connecting element (25) electrically interconnecting the second electrode (23) and the solar cell (24); and
a frame (26) disposed on the substrate, wherein the solar cell is located in the frame.

2. The concentration photovoltaic module as claimed in claim 1, wherein the solar cell comprises a positive electrode (241) and a negative electrode (242), and one of the positive electrode and the negative electrode is electrically connected to the first electrode and the other is electrically connected to the second electrode.

3. The concentration photovoltaic module as claimed in claim 1, wherein the first electrode and one electrode of the solar cell are of the same polarity, and the second electrode and the other electrode of the solar cell are of the same polarity.

4. The concentration photovoltaic module as claimed in any of the preceding claims, further comprising two conductive wires electrically connected to the first electrode and the second electrode, respectively.

5. The concentration photovoltaic module as claimed in claim 4, wherein the conductive wires are electrically connected to an electrical device to transmit electrical energy of the solar cell to the electrical device.

6. The concentration photovoltaic module as claimed in any of the preceding claims, wherein the solar cell is connected to the first electrode (22) by tin soldering or a conductive adhesive.

7. The concentration photovoltaic module as claimed in any of the preceding claims, wherein the substrate (21) is made of ceramic, sapphire, aluminum nitride (A1N), silicon carbide (SiC) or beryllium oxide (BeO).

8. The concentration photovoltaic module as claimed in any of the preceding claims, further comprising an optical element (23) disposed on the frame (26).

9. The concentration photovoltaic module as claimed in claim 8, wherein the optical element is a transparent protect cover, a polymer, a reflecting mirror, a lens or an element with high transmittance.

10. The concentration photovoltaic module as claimed in claim 8 or 9, wherein an inner edge of the upper frame has an annular groove (262) with a depth for allowing the optical element (27) to be installed therein.

11. The concentration photovoltaic module as claimed in any of the preceding claims, wherein the frame (26) has a cavity (261).

12. The concentration photovoltaic module as claimed in any of the preceding claims, wherein the frame (26) is made of a ceramic material and/or is rectangular, round or polygonal.

13. The concentration photovoltaic module as claimed in any of the preceding claims, further comprising medium (29) filled in the frame (26) for packaging the solar cell.

14. The concentration photovoltaic module as claimed in claim 13, wherein the medium (29) is a transparent adhesive, a polymer material or a material with high transmittance and/or wherein the medium has a refractive index close to the optical element.

15. The concentration photovoltaic module as claimed in any of the preceding claims, further comprising a connecting layer disposed under the substrate and connected to a heat dissipating seat to conduct the heat from the concentration photovoltaic module to the heat dissipating seat.

16. The concentration photovoltaic module as claimed in claim 15, wherein the connecting layer is disposed under the substrate via coating or printing and/or wherein the connecting layer is a silver paste.
